# EUROPEAN PATENT APPLICATION

(11) **EP 2 767 884 A2**
(43) Date of publication of application: **20.08.2014**
(21) Application number: 13177667.6
(22) Date of filing: 23.07.2013
(51) Int. Cl.: G06F 1/18

(54) **Case for electronic device**

(30) Priority: 19.02.2013 TW 102203188
(71) Applicant: Compal Broadband Networks Inc., 114 Taipei City (TW)
(72) Inventor: Yang, Tzu-Yueh, Taichung City 433 (TW); Peng, Chien-Fen, Zhubei City Hsinchu County 302 (TW); Hsu, Hsiao-Yin, Zhubei City Hsinchu County 30265 (TW); Chiu, Chih-Hsin, Zhubei City Hsinchu County 302 (TW)
(74) Representative: Becker Kurig Straus

(57) **Abstract**

A case (10) for an electronic device including at least one imperforate area (100, 102), at least one heat dissipation area (104, 106), wherein each heat dissipation area (104, 106) forms at least one heat dissipation hole for providing heat dissipation of the electronic device, at least one groove (108, 110) formed between the at least one imperforate area (100, 102) and the at least one heat dissipation area (104, 106), a button element (112) including at least one button (114, 116) for pressing at least one corresponding button of the electronic device and a void element (120) forming at least one hole (122-130) for exposing at least one corresponding jack of the electronic device to the outside of the case (10).

## Description

### Field of the Invention

The invention relates to a case for an electronic device, and relates especially to a case capable of effectively helping the electronic device dissipate heat and capable of changing into different appearances according to requirements.

### Background of the Invention

With increased numbers of integrated functions in an electronic device, the numbers of required elements and operating speed of the elements in the electronic device are also increased. For example, a modem has a network accessing functionality and also integrates a phone recording functionality, or a media playing functionality, etc. Under such a condition, if a case of the electronic device cannot provide an effective way to dissipate heat, the electronic device may be damaged due to a high temperature inside the case. Therefore, the case for protecting the electronic device is often required to feature heat dissipation holes or fans inside the case to help the electronic device dissipate heat.

However the heat dissipation holes in the case may affect the appearance of the case. Further, if locations and types of the heat dissipation holes of the case have been already designed, the appearance of the case is not easily changed. Therefore it is one of the industry goals to manufacture a case capable of effectively helping the electronic device dissipate heat and capable of flexibly changing its appearance.

### Summary of the Invention

The present invention aims at providing a case for an electronic device capable of effectively helping the electronic device dissipate heat and capable of changing into different appearances according to requirements.

This is achieved by a case according to claim 1. The dependent claims pertain to corresponding further developments and improvements.

As will be seen more clearly from the detailed description following below, the claimed case for an electronic device comprises at least one imperforate area; at least one heat dissipation area, wherein each heat dissipation area forms at least one heat dissipation hole for providing heat dissipation of the electronic device; at least one groove, formed between the at least one imperforate area and the at least one heat dissipation area; a button element, comprising at least one button, for pressing at least one corresponding button of the electronic device; and a void element, forming at least one hole, for exposing at least one corresponding jack of the electronic device to the outside of the case.

### Brief Description of the Drawings

The invention is further illustrated by way of example with reference to the accompanying drawings. Thereof,
FIG. 1 is a front isometric view of a case according to an embodiment of the present invention,
FIG. 2 is a back isometric view of the case according to an embodiment of the present invention,
FIG. 3 is a schematic diagram of the segmented case in FIG. 1, and
FIG. 4 is a bottom view of the case in FIG. 1.

### Detailed Description

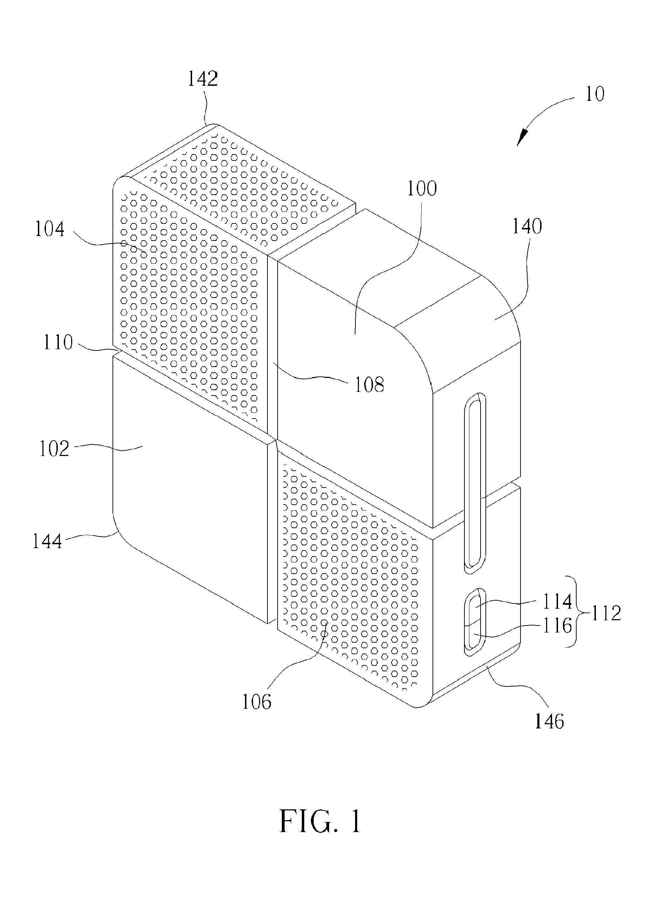

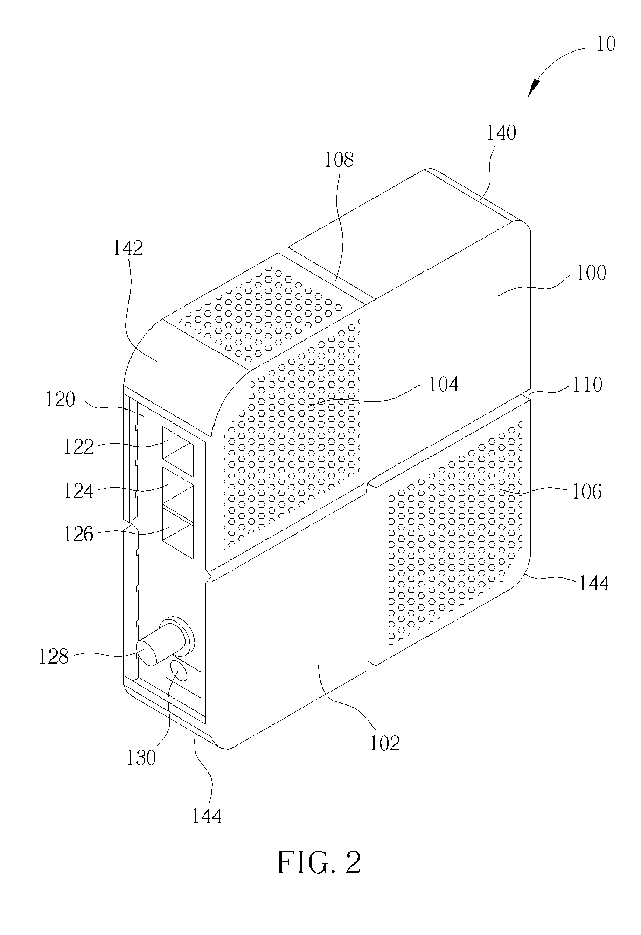

FIG. 1 is a front isometric view of a case 10 according to an embodiment of the present invention. FIG. 2 is a back isometric view of the case 10 according to an embodiment of the present invention. As shown in FIG. 1 and FIG. 2, the case 10 is a rectangle and is constructed by connecting a front panel, a back panel, and four side panels, wherein the front panel and the back panel are connected and substantially perpendicular to the four side panels and the front panel is substantially parallel to the back panel. The case 10 includes imperforate areas 100, 102, heat dissipation areas 104, 106, grooves 108, 110, a button element 110, and a void element 120. The imperforate areas 100, 102 and the heat dissipation areas 104, 106 are formed on the four side panels, the button element 110 is formed on the front panel, and the void element 120 is formed on the back panel. The case 20 may be made by materials such as plastic or metal, and may be formed by two or more elements with a locking or bonding method, wherein the elements are integrally made or implemented by utilizing the bonding method. The grooves 108, 110 divide the surface of the case 10 into separated areas. The separated areas are respectively the imperforate areas 100, 102 and the heat dissipation areas 104, 106, so as to highlight a fashion sense. The imperforate areas 100 and 102 are diagonally disposed and the heat dissipation areas 104 and 106 are also diagonally disposed, wherein the imperforate areas 100, 102 and the heat dissipation areas 104, 106 are interlaced. The imperforate areas 100, 102 and the heat dissipation areas 104, 106 may also be disposed in other forms, and are not limited herein.

Surfaces of the imperforate areas 100, 102 are brighter in color than surfaces of the heat dissipation areas 104, 106, and have no holes so that the electronic device is protected from damage. The surfaces of the heat dissipation areas 104, 106 may be opaque and have heat dissipation holes. The heat dissipation holes may be arranged in order and in substantially fixed intervals to provide for dissipating heat from the electronic device. Sizes of the heat dissipation holes and interval distances between the heat dissipation holes may also be designed according to a required degree of heat dissipation. The grooves 108, 110 are formed between the imperforate areas 100, 102 and the heat dissipation areas 104, 106. The grooves 108, 110 are V-shaped grooves but may be other shaped grooves, such as U-shaped grooves or round-shaped grooves, etc. The grooves 108, 110 form fashionable lines in the case 10 and may provide buffer areas between the imperforate areas 100, 102 and the heat dissipation areas 104, 106, such that when the surfaces of the imperforate areas 100, 102 are different from the surfaces of the heat dissipation areas 104, a more complex manufacturing process for a situation of the imperforate areas 100, 102 being too close to the heat dissipation areas 104 may be avoided due to the existence of the buffer area. As a result, the manufacturing cost of the case is not increased, and the case may also have a beautiful appearance with the different surfaces.

The button element 112 includes buttons 114, 116 for pressing functional buttons of the electronic device. For example, when the electronic device is a modem having a wireless communication functionality, the buttons 114, 116 may be configured as a wireless turning on button and a wireless turning off button of the electronic device, so as to turn on the wireless function of the electronic device by pressing the button 114 and turn off the wireless function of the electronic device by pressing the button 116. Button numbers and locations (e.g. on a front plate or on a back plate of the case 10) of the button element 112 may be changed according to the requirements of the device, and are not limited herein.

The void element 120 forms holes 122-130 for exposing external jacks of the electronic device to the outside of the case 10 so as to be plugged with a connecting line by a user. For example, the hole 122 may be a phone jack of a modem, the holes 124, 126 may be network jacks of the modem, the hole 128 may be a cable jack of the modem, and the hole 130 may be a power jack of the modem, etc. Hole numbers and locations of the void element 120 may also be adjusted according to the requirements of the device.

Furthermore, four corners 140-146 of the case 10 are designed as arc-shaped corners, and an arc degree of the corner 140 is greater than arc degrees of the corners 142, 144 , and 146, such that the case 10 may be more beautiful when the case is viewed from front side.

In short, the imperforate areas 100, 102 and the heat dissipation areas 104, 106 are divided to be arranged relative to the grooves 108, 110. The case 10 is then fashionable and the numbers of the imperforate areas and the heat dissipation areas may be flexibly increased or decreased and the disposal locations of the imperforate areas and the heat dissipation areas may also be changed according to the requirements, so as to help the electronic device dissipate heat and form a variety of appearances of the case 10. Moreover, since the imperforate areas 100, 102 and the heat dissipation areas 104, 106 are formed by the grooves 108, 110, the buffer areas between the imperforate areas 100, 102 and the heat dissipation areas 104, 106 may be increased, such that the manufacturing complexity and cost for manufacturing the different surfaces is not increased.

Furthermore, the locations of the heat dissipation areas 104, 106 may be changed according to the requirements of the device. When the case 10 is stood on its side or end and the locations of the heat dissipation areas 104, 106 are found on top-front and bottom-back sides of the case 10 respectively, cold air may flow through the heat dissipation area 106 located on the bottom side of the case 10, and after the cold air is heated to be hot air inside the case 10, the hot air may flow out of the case 10 through the heat dissipation area 104 located on the top side of the case 10. Since the design of the heat dissipation areas 104, 106 meets characteristics of the cold and hot air, air convection is accelerated to effectively help the electronic device dissipate heat.

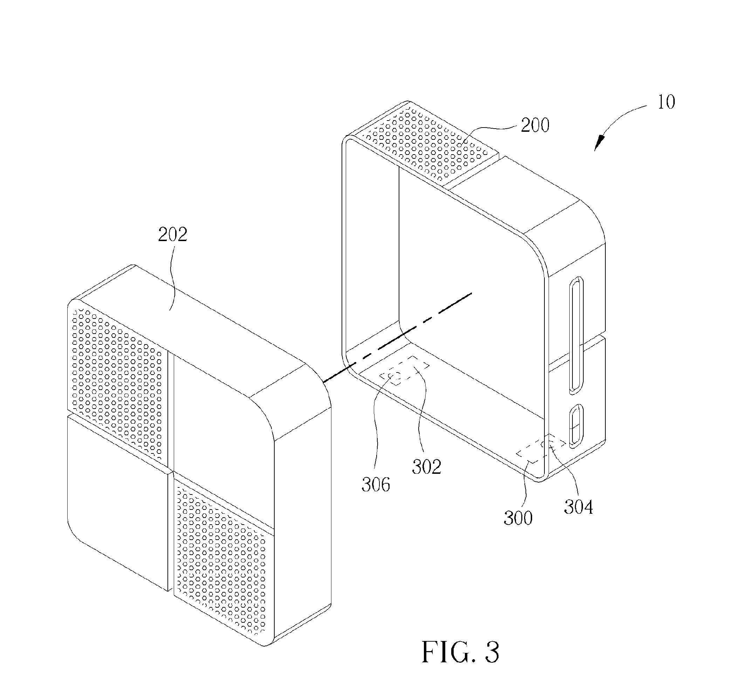

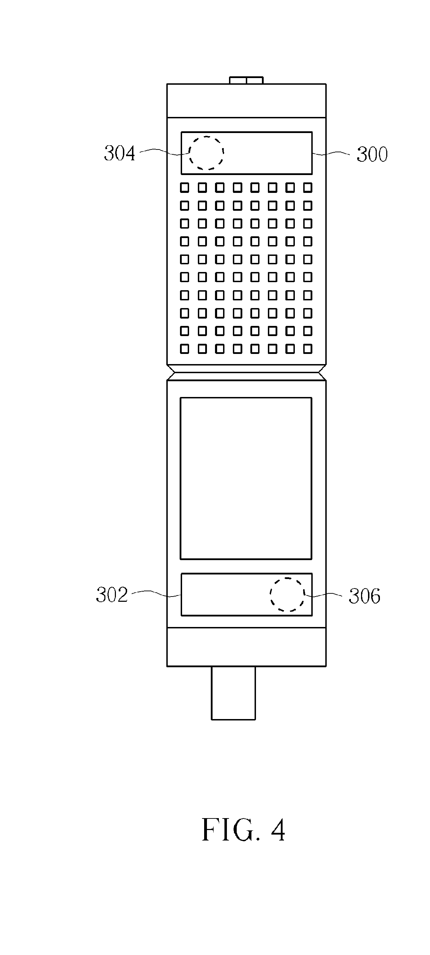

The implementing method of the case 10 is not limited. FIG. 3 is a schematic diagram of the segments of the case 10. FIG. 4 is a bottom view of the case 10. As shown in FIG. 3, an upper cover 200 and a lower cover 202 combine to form the case 10. The upper cover 200 and the lower cover 202 may be made of materials such as Acrylonitrile Butadiene Styrene (ABS) resin, glass fiber, iron, or aluminum, etc, and may each be integrally made or formed by other bonding methods. Moreover, as shown in FIG. 4, the bottom plate of the case 10 includes lock elements 300, 302, which respectively include screw holes 304, 306. Therefore, the screw holes 304, 306 may be combined with screws to lock the upper cover 200 to the lower cover 202 to form the case 10. Surfaces of the lock elements 300, 302 may have a flat sheet, which may cover the screw holes 304, 306 for a beautiful appearance.

The case 10 is formed by a combination of the upper cover 200 and the lower cover 202 with the upper cover 200 and the lower cover 202 fixed together by a locking method. The upper cover 200 and the lower cover 202 may be each integrally made by a mold to form the imperforate areas, the heat dissipation areas, and the grooves, so as to help the electronic device dissipate heat and change the different appearances according to the requirements. Moreover, the complexity and cost of manufacturing are also not increased.

The present invention utilizes the grooves to form the imperforate areas and the heat dissipation areas for flexibly changing the appearances and configuring the heat dissipation areas, so as to effectively help the case 10 dissipate heat. Those skilled in the art can make modifications or alterations accordingly. For example, in the embodiment, the case 10 has a basically rectangular shape and arc corners. In another embodiment, the case 10 may also be a round shape or a cylinder shape, etc, and is not limited. When the grooves, the imperforate areas and the heat dissipation area are formed on a surface of the round-shaped case, similarly the heat dissipation may also be effectively achieved and the case may also have the fashionable appearance.

In the embodiment, the heat dissipation holes are square holes and are arranged in order and in substantially fixed intervals. In other embodiments, the heat dissipation holes may also be round shaped, diamond shaped, or other shapes, and may be arranged not in order and not in fixed intervals. Moreover, the grooves may also be designed to be arranged in parallel and not in perpendicular fashion, such that the case is divided by the grooves in parallel to form the several imperforate areas and the several heat dissipation areas, alterations which may be made according to the actual requirements and manufacturing cost.

Additionally, in the embodiment, the upper cover 200 and the lower cover 202 combine to form the case 10. However, in other embodiments, the case 10 may also be formed by three or more components. For example, the case 10 may be formed by combining an upper plate, a lower plate, a front plate, a back plate, and a side plate, or the case 10 may also be formed by combining one of the plates with another integrally made component.

In summary, the locations and the types of the heat dissipation holes of the case have been already designed in the prior art and the appearance of the case is not easy to be changed by the designer. In comparison, the case for the electronic device provided by the present invention may configure the numbers and the locations of the heat dissipation areas according to the heat dissipation requirements to help the electronic device dissipate heat and form a variety of fashionable appearances.

## Claims

1. A case (10) for an electronic device, **characterized by** the case (10) comprising:
at least one imperforate area (100, 102), formed on a first surface of the case (10);
at least one heat dissipation area (104, 106), formed on the first surface of the case (10), wherein each heat dissipation area (104, 106) forms at least one heat dissipation hole for providing heat dissipation of the electronic device;
at least one groove (108, 110) formed between the at least one imperforate area (100, 102) and the at least one heat dissipation area (104, 106);
a button element (112), formed on a second surface of the case (10), and comprising at least one button (114, 116) for pressing at least one corresponding button of the electronic device; and
a void element (120), formed on a third surface of the case (10), and forming at least one hole (122-130) for exposing at least one corresponding jack of the electronic device to the outside of the case (10);
wherein the second surface and the third surface are respectively connected and substantially perpendicular to the first surface, and the second surface is substantially parallel to the third surface.

2. The case (10) of claim 1, **characterized in that** a surface of the at least one imperforate area (100, 102) is a brighter color than a surface of the at least one heat dissipation area (104, 106).

3. The case (10) of claim 1, **characterized in that** the at least one heat dissipation area (104, 106) has an opaque surface.

4. The case (10) of claim 1, **characterized in that** the at least one heat dissipation area (104, 106) is disposed on a diagonal location of the case (10), such that air convection accelerates the heat dissipation of the electronic device.

5. The case (10) of claim 1, **characterized in that** the at least one groove (108, 110) is a V-shaped groove.

6. The case (10) of claim 1, **characterized in that** the electronic device is a modem.

7. The case (10) of claim 6, **characterized in that** the at least one button (114, 116) is configured to correspond to a wireless turning on button and a wireless turning off button of the electronic device.

8. The case (10) of claim 6, **characterized in that** the at least one hole (122-130) is configured to correspond to an Internet jack and a power jack of the electronic device.

9. The case (10) of claim 1, **characterized in that** the case (10) further comprises:
at least one arc-shaped corner (142-146), wherein each arc-shaped corner (142-146) has a first arc degree.

10. The case (10) of claim 9, **characterized in that** the case (10) further comprises an arc-shaped corner (140), wherein the arc-shaped corner (140) has a second arc degree, and the second arc degree is greater than the first arc degree.

11. The case (10) of claim 1, **characterized in that** an upper cover (200) and a lower cover (202) combine to form the case (10).

12. The case (10) of claim 11, **characterized in that** the case (10) further comprises:
a lock element (300, 302), comprising at least one screw hole (304, 306), for locking the upper cover (200) to the lower cover (202).

13. The case (10) of claim 11, **characterized in that** the upper cover (200) and the lower cover (202) are each integrally made.
